# EUROPEAN PATENT APPLICATION

(11) **EP 2 930 143 A1**
(43) Date of publication of application: **14.10.2015**
(21) Application number: 15154692.6
(22) Date of filing: 11.02.2015
(51) Int. Cl.: C01B 31/04, B82Y 30/00, H01B 1/04, H01L 23/52, H01L 23/532

(54) **Wiring**

(30) Priority: 13.03.2014 JP 2014049654
(71) Applicant: Kabushiki Kaisha Toshiba, Tokyo 105-8001 (JP)
(72) Inventor: Yamazaki, Yuichi, Tokyo, 105-8001 (JP); Yoshida, Takashi, Tokyo, 105-8001 (JP); Nishida, Yasutaka, Tokyo, 105-8001 (JP); Miyazaki, Hisao, Tokyo, 105-8001 (JP); Aiga, Fumihiko, Tokyo, 105-8001 (JP); Sakai, Tadashi, Tokyo, 105-8001 (JP)
(74) Representative: Granleese, Rhian Jane

(57) **Abstract**

A wiring includes a graphene having a five-seven-membered ring-dense region. The graphene has a plurality of unit cells each including a five-seven-membered ring. The length of the unit cell is 1 nm or more. The shortest distance between most closely adjacent unit cells among the unit cells is 5 nm or less in the five-seven-membered ring-dense region.

## Description

### CROSS-REFERENCE TO RELATED APPLICATION

This application is based upon and claims the benefit of priority from Japanese Patent Application No. 2014-049654 MARCH 13, 2014.

### FIELD

Embodiments described herein relate to a wiring.

### BACKGROUND

The graphene is a two-dimensional nano-material formed of carbon atoms. This material has extremely excellent physical properties such as high current density resistance, ultra-high mobility, high heat resistance and high mechanical strength, and is therefore considered promising as a next-generation new material. For example, a graphene nano-ribbon processed to a width of about 10 nm is theoretically predicted to have an electric conductivity exceeding that of copper. For this reason, studies have been being conducted on applications of graphene wirings.

The electric conductivity of the graphene nano-ribbon depends on the number of quantized channels. Since the number of channels decreases as the line width becomes narrower, it is difficult to realize a resistance as low as that of a metal with an extremely fine graphene nano-ribbon. On the other hand, it has been confirmed both experimentally and theoretically that in the graphene nano-ribbon, unlike a metal, an edge state is generated when the atomic structure at the end becomes a zigzag structure. The edge state functions as a conduction channel irrespective of a line width, and is therefore very effective for lowering the resistance of the extremely fine graphene nano-ribbon.

Thus, in the graphene, a new conduction channel can be generated according to a bonding/arrangement state of carbon atoms. In recent years, there have been reported novel carbon atom arrangements which can function as a conduction channel with a five-seven-membered ring zigzag structure in which the end structure includes a five-membered ring and a seven-membered ring, a structure in which a defect line including a five-membered ring and an eight-membered ring exists in a graphene nano-ribbon, and so on in addition to the above-described zigzag structure.

### BRIEF DESCRIPTION OF THE DRAWINGS

FIG. 1 is a perspective schematic view of a wiring of an embodiment;
FIG. 2 is a perspective schematic view of a wiring of an embodiment;
FIG. 3 is a perspective schematic view of a wiring of an embodiment; and
FIG. 4 is a perspective schematic view of a wiring of an embodiment.

### DETAILED DESCRIPTION

A wiring includes a graphene having a five-seven-membered ring-dense region. The graphene has a plurality of unit cells each including a five-seven-membered ring. The length of the unit cell is 1 nm or more. The shortest distance between most closely adjacent unit cells among the unit cells is 5 nm or less in the five-seven-membered ring-dense region.

### (Embodiment 1)

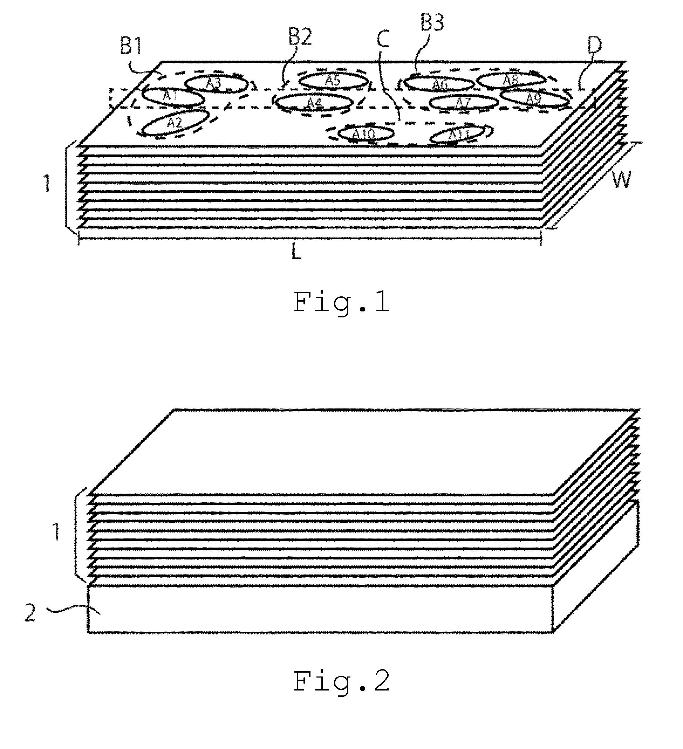

A wiring of embodiment 1 has in a graphene 1 a plurality of unit cells A of graphene each including a five-seven-membered ring. FIG. 1 shows a perspective schematic view of a wiring of embodiment 1. The wiring shown in FIG. 1 has a plurality of unit cells A in the graphene 1. A region where a plurality of unit cells A densely exist is a five-seven-membered ring-dense region B. For example, the wiring of the embodiment is used for a wiring in a semiconductor device. The width of the graphene 1 (wiring) is denoted by W, and the length (distance in the wiring direction) of the graphene 1 is denoted by L.

The graphene 1 having the unit cell A is preferably a monolayer graphene or multilayer graphene with a layer number of not less than 1 and not more than 50, which includes a flat-shaped graphene sheet in the form of a monolayer or a plurality of laminated layers. The graphene 1 is a single crystal. The wiring is preferably in the form of a ribbon, for example a wiring of graphene nano-ribbons. The wiring width (W) of the graphene 1 is typically 1 nm or more and 100 nm or less. It is preferred that the unit cell A does not contain carbon atoms that form the end of the graphene 1. When considering wiring performance, the end of the graphene 1 is preferably, but not necessarily, in a zigzag shape that functions as a conduction channel. The layer number and wiring width (W) of the graphene 1 can be measured by, for example, a transmission electron microscope.

When the graphene 1 is a multilayer, it is preferred that two or more layers contain the unit cell A and the five-seven-membered ring dense region B from the viewpoint of lowering the resistance of the wiring. When the graphene 1 is a multilayer, it is more preferred that two or more layers contain the unit cell A and the five-seven-membered ring dense region B from the same viewpoint as described above.

The unit cell A is a five-seven-membered ring in which five-membered ring structures and seven-membered ring structures are alternately continued in the graphene 1. The continued five-membered ring structures and seven-membered ring structures have a fused cyclic compound structure. The length of the unit cell A is a distance between two carbon atoms farthest from each other among carbon atoms of the five-membered rings and seven-membered rings that form the unit cell A. In the embodiment, the unit cell A is one in which the distance between these carbon atoms is 1 nm or more.

In the graphene 1, regions of structures other than six-membered ring structure, such as five-membered ring structure and seven-membered ring structure, have been heretofore actively reduced because regions of such structures are treated as defects. However, it has become apparent that the graphene 1 containing the unit cell A has a lower resistance as compared to a graphene having no or reduced defects.

It is preferred that the unit cell A forms a line in which five-membered ring structures and seven-membered ring structures are alternately continued from the viewpoint of lowering the resistance of the wiring, but the unit cell A may contain a portion in which five-membered ring structures are continued and a portion in which seven-membered ring structures are continued. The continued five-membered ring structure and five-membered ring structure and the continued seven-membered ring structure and seven-membered ring structure each have a fused cyclic compound structure. When a distance between unit cells A is measured, a portion in which five-membered ring structures are continued and a portion in which seven-membered ring structures are continued are also measured as regions of unit cell A.

The length of the unit cell A is more preferably 5 nm or more from the viewpoint of improvement of conductivity.

The five-seven-membered ring-dense region B contains a plurality of dense unit cells A. The distance between most closely adjacent unit cells A in the region B is preferably 5 nm or less. The unit cell A has a low resistance and therefore easily forms a conductive path D in the wiring, but when the distance between adjacent unit cells A is excessively large, a distant unit cell A is not contained in the conductive path D, and therefore does not contribute to lowering of the resistance. One or more five-seven-membered ring-dense regions B are contained in the graphene 1 of one layer. The conductive path D is conceptually illustrated, and the conductive path D in an actual wiring is not limited thereto.

The unit cell A and the five-seven-membered ring dense region B will be further described with reference to FIG. 1. The wiring (graphene 1) of FIG. 1 includes a five-seven-membered ring-dense region B1 containing unit cells A1 to A3, a five-seven-membered ring-dense region B2 containing unit cells A4 and A5, a five-seven-membered ring-dense region B3 containing unit cells A6 to A9, and a non-dense region C containing unit cells A10 and A11. The distance between most closely adjacent unit cells among unit cells contained in five-seven-membered ring-dense regions B is 5 nm or less. The distance between most closely adjacent unit cells A11 and A11 is more than 5 nm. Therefore, the region containing unit cells A10 and A11 is defined as the five-seven-membered ring-non-dense region C because it does not satisfy the requirement of the five-seven-membered ring-dense region B. The conductive path D extends through the five-seven-membered ring-dense regions B1 to B3, and does not include the five-seven-membered ring-non-dense region C. There may be one conductive path D in the five-seven-membered ring-dense regions B as in FIG. 1, or there may be a plurality of conductive paths D in the graphene 1.

The graphene 1 of the embodiment has within a range of ±1.5 eV a state density peak in a new electron state attributed to an arrangement of carbon atoms in the unit cell A. Due to the presence of this electron state, the electron state of the unit cell A acts as an additional conduction channel. The conduction channel from the unit cell A forms a conductive path of the wiring, so that the wiring of the embodiment becomes a wiring having a lower resistance as compared to a graphene having no unit cell and including only six-membered rings. While the fermi level (Ef) of a graphene nano-ribbon in an ideal state is 0 eV, doping may be performed for the graphene 1 to have a lower resistance. When holes or electrons are hereby supplied to the graphene 1, the fermi level is changed. The fermi level of the graphene nano-ribbon 1 at this time is adjusted to be within a range of not less than -1.5 eV and not more than +1.5 eV (within a range of ±1.5 eV), preferably not less than -1.0 eV and not more than +1.0 eV (within a range of ±1.0 eV). More preferably, the state density peak is also within a range of ±1.0 eV. When the fermi level of the graphene nano-ribbon 1 is within the above-mentioned range, the electron state of the unit cell A acts as an additional conduction channel due to the presence of a new electron state attributed to the five-seven-membered ring of the unit cell A, so that the unit cell A forms a conductive path D of a wiring having a low resistance.

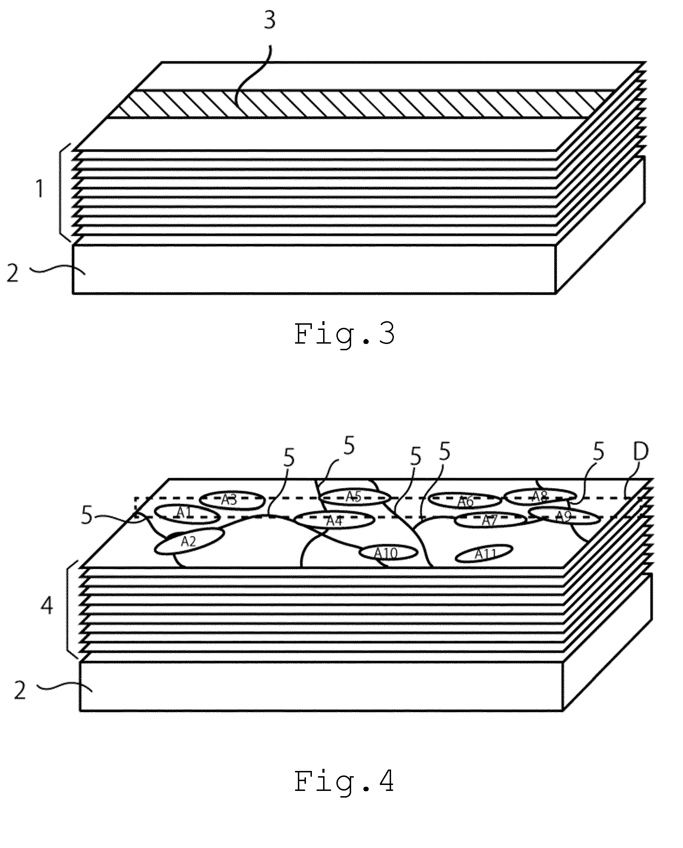

A preparation method in embodiment 1 will now be described with reference to process schematic views in FIGS. 2 and 3. First, as shown in FIG. 2, a transfer process, a fine lithography technique or the like is used to prepare a graphene nano-ribbon 1 in a region where a wiring is formed. A graphene nano-ribbon may be directly formed by selective growth. Here, the graphene nano-ribbon 1 is prepared on a substrate 2.

Next, a damage region 3 is formed by irradiating the graphene nano-ribbon 1 with an electron ray beam, of which the accelerating voltage is adjusted. When the accelerating voltage of the electron beam is approximately not less than 10 kV and not more than 200 kV in terms of an intensity, the honeycomb structure of carbon atoms is damaged to be converted into the damage region 3. An atomic beam of H, He or the like may be used in place of an electron beam, but in the case of the atomic beam, caution is needed because carbon atoms may be forced out from the honeycomb structure under the condition of a relatively low accelerating voltage (several hundreds V or less). The electron beam or atomic beam arrives at a graphene at a deep part of multilayer graphenes, so that the damage region 3 can be formed on graphenes at the surface layer and deep layers. The width, the location and so on of the damage region 3 are not strictly limited. One region or a plurality of regions can be formed as the damage region 3. For example, a relatively wide damage region 3 may be formed near the center in the graphene nano-ribbon 1, or a plurality of relatively narrow damage regions 3 may be formed. Since the length of the conductive path D is preferably large from the viewpoint of lowering the resistance, it is preferred to irradiate the graphene nano-ribbon with an electron beam so as to form the linear damage region 3 in a lengthwise direction (L) of the wiring.

Next, carbon atoms are rearranged by a heat treatment. When the graphene nano-ribbon 1 is heat-treated, some or all of carbon backbones in the damage region 3 are formed into five-membered ring structures and seven-membered ring structures, so that the five-seven-membered ring-dense region B containing the unit cell A is formed on the graphene nano-ribbon 1. Higher the temperature of the heat treatment (higher than 1000°C), more easily the six-membered ring structure is formed. Thus, in the embodiment, it is desirable that the treatment temperature be 1000°C or lower. The atmosphere during heat treatment is preferably a non-combustive atmosphere, such as that of Ar. The time of the heat treatment depends on a heating temperature, but typically is preferably not less than 1 minute and not more than 60 minutes.

### (Embodiment 2)

A wiring of embodiment 2 is formed by using a polycrystal graphene 4 in place of the graphene 1 of embodiment 1. Embodiment 1 and embodiment 2 are the same except for the crystallinity of the graphene. Descriptions and some symbols in the drawings for the matters common to embodiment 1 and embodiment 2 are omitted. FIG. 4 is a perspective schematic view of the wiring of embodiment 2. The wiring in FIG. 4 has a plurality of unit cells A in the polycrystal graphene 4 having a grain boundary 5. A region where a plurality of unit cells A densely exist is a five-seven-membered ring-dense region B. The polycrystal graphene 4 itself has the disadvantage that owing to the grain boundary 5, the electric conductivity is low as compared to the single-crystal graphene 1. However, when the polycrystal graphene 4 has the five-seven-membered ring-dense region B that is a region where a plurality of unit cells densely exist, the unit cell A forms a conductive path D. Even in the case of the polycrystal graphene 4, the region of the unit cell A is not affected or only slightly affected by a reduction in electric conductivity by the grain boundary 5, and therefore when the conductive path D having a low resistance exists in the polycrystal graphene 4, a wiring having a lower resistance can be obtained. The wiring of embodiment 2 can be formed as a wiring in which the conductive path D does not extend over the grain boundary 5 or almost does not extend over the grain boundary 5 although the polycrystal graphene 4 is used. The polycrystal graphene 4 can be formed by, for example, a chemical vapor deposition method using a catalyst metal. The wiring of the embodiment has the advantage that the wiring has the conductive path D having a low resistance irrespective of whether the graphene is a single crystal or a polycrystal.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A wiring comprising a graphene having a five-seven-membered ring-dense region, wherein the graphene has a plurality of unit cells each comprising a five-seven-membered ring, the length of the unit cell is 1 nm or more, and the shortest distance between most closely adj acent unit cells among the unit cells is 5 nm or less in the five-seven-membered ring-dense region.

2. The wiring according to claim 1, wherein the unit cell further comprises a five-five-membered ring and a seven-seven-membered ring.

3. The wiring according to claim 1 or 2, wherein the wiring comprises a plurality of five-seven-membered ring-dense regions.

4. The wiring according to any of the preceding claims, wherein the width of the graphene is 100 nm or less, and the graphene is in the form of a ribbon.

5. The wiring according to any of the preceding claims, wherein the graphene has within a range of ±1.5 eV a state density peak attributed to the five-seven-membered ring-dense region.

6. The wiring according to any of the preceding claims, wherein the fermi level of the graphene is within a range of ±1.5 eV as a result of doping.

7. The wiring according to any of the preceding claims, wherein the graphene is a single crystal or a polycrystal having a grain boundary.

8. The wiring according to any of the preceding claims, wherein the graphene is a monolayer graphene or a multilayer graphene having 100 or less layers.
